# EUROPEAN PATENT APPLICATION

(11) **EP 3 570 331 A1**
(43) Date of publication of application: **20.11.2019**
(21) Application number: 19174957.1
(22) Date of filing: 16.05.2019
(51) Int. Cl.: H01L 31/048, H01L 31/049

(54) **BACK SHEET AND ENCAPSULANT FOR SOLAR CELLS AND SOLAR CELL MODULE COMPRISING THE SAME**

(30) Priority: 18.05.2018 KR 20180056966
(71) Applicant: SKC eco-solutions Co., Ltd., Chungcheongbuk-do 27818 (KR)
(72) Inventor: LEE, Sun Ki, 16546 Gyeonggi-do (KR); YU, A Rim, 06242 Seoul (KR); HAN, Kweon Hyung, 16510 Gyeonggi-do (KR)
(74) Representative: Dehns

(57) **Abstract**

Embodiments relate to a back sheet and an encapsulant for solar cells and a solar cell module comprising at least one of the same. The back sheet for solar cells comprises an infrared reflecting layer to increase the power generation efficiency of the solar cells and maintain the black color of the products even when exposed to strong light.

## Description

### [Technical Field]

Embodiments relate to a back sheet and an encapsulant for solar cells and a solar cell module comprising the same. The back sheet and the encapsulant for solar cells each comprise an infrared ray reflecting layer to increase the power generation efficiency of the solar cells and maintain the black color of the products even when exposed to strong light.

### [Background Art]

A solar cell module is composed of glass, a solar cell, an encapsulant, and a back sheet. The back sheet among the above is fused with the encapsulant that fixes the solar cell on the back side of the solar cell module, thereby protecting the module from physical impact, moisture, and other contaminants of the external environment. Meanwhile, a back sheet having a high reflectance is required in order to increase the power generation capacity of a solar cell module. This is because the sunlight incident on the solar cell is reflected on the back sheet and totally reflected on the glass surface to be transmitted to the cell, thereby contributing to the enhancement in the output of the solar cell. However, since a back sheet of black color applied to a building integrated photovoltaic (BIPV) system that has been increasingly adopted in recent years generally uses carbon black as a black pigment, it absorbs light not only in the visible light region but also in the infrared region, which lowers the reflectance of the back sheet. There is also a disadvantage that the temperature of the solar cell module rises, which lowers the output thereof.

In order to overcome the above disadvantages, a back sheet containing an organic or inorganic pigment that absorbs light in the visible light region, thereby maintaining the black color, while transmitting or reflecting light in the infrared region has been developed.

For example, Korean Laid-open Patent Publication No. 2015-0003741 discloses a back sheet for solar cells that comprises an infrared ray reflective inorganic pigment and has a reflectance of greater than 25% for light of a wavelength of 1,000 nm to 2,100 nm and a reflectance of less than 35% for light of a wavelength of 380 nm to 750 nm. Japanese Patent No. 6008620 also discloses a back sheet for solar cells that comprises an infrared ray reflective pigment.

### [Disclosure of the Invention]

### [Technical Problem]

However, the back sheet for solar cells disclosed in Korean Laid-open Patent Publication No. 2015-0003741 has a problem of low reflection performance in an infrared region (e.g., 750 nm to 1,100 nm), in which the power generation efficiency of a cell is high, since it comprises a typical infrared ray reflective black pigment. In addition, the back sheet for solar cells disclosed in Japanese Patent No. 6008620 has a high infrared ray reflection performance, whereas it involves a phenomenon that the back sheet is visually observed as green or purple depending on the characteristics of the pigment when exposed to strong light (or upon transmission thereof). This can be a significant disadvantage for applications to the BIPV system or the like where aesthetic factors are important.

Therefore, an object of the embodiments is to provide a back sheet for solar cells that has a high reflectance in an infrared region (e.g., 750 nm to 1,100 nm), in which the power generation efficiency of a cell is high, and that the conventional problem that it is visually observed as green or purple upon transmission of light is solved. In addition, another object of the embodiments is to provide an encapsulant for solar cells and a solar cell module having the excellent characteristics of the back sheet for solar cells as described above.

### [Solution to the Problem]

An embodiment to achieve the above object provides a back sheet for solar cells, which comprises an infrared reflecting layer comprising a resin and an inorganic pigment, wherein the inorganic pigment comprises a first inorganic pigment comprising bismuth (Bi); and a second inorganic pigment comprising at least two selected from the group consisting of cobalt (Co), magnesium (Mg), nickel (Ni), chromium (Cr), aluminum (Al), zinc (Zn), and titanium (Ti), and the back sheet for solar cells has an average reflectance of 45% or more in a wavelength range of 750 nm to 1,100 nm.

Another embodiment provides an encapsulant for solar cells, which comprises an infrared reflecting layer comprising a resin and an inorganic pigment, wherein the inorganic pigment comprises a first inorganic pigment comprising bismuth (Bi); and a second inorganic pigment comprising at least two selected from the group consisting of cobalt (Co), magnesium (Mg), nickel (Ni), chromium (Cr), aluminum (Al), zinc (Zn), and titanium (Ti), and the encapsulant for solar cells has an average reflectance of 45% or more in a wavelength range of 750 nm to 1,100 nm.

Still another embodiment provides a solar cell module, which comprises the back sheet for solar cells and/or the encapsulant for solar cells as described above.

### [Advantageous Effects]

The back sheet and the encapsulant for solar cells according to the embodiments improve the problem that they are visually observed as green or purple upon transmission of light, which is a disadvantage of the conventional black back sheet, without remarkably deteriorating the reflection performance thereof. They are also excellent in reflectance in an infrared region (e.g., 750 nm to 1,100 nm), in which the power generation efficiency of a cell is high. Accordingly, the back sheet and the encapsulant for solar cells according to the embodiments can increase the output while maintaining black color and aesthetic features even when exposed to strong light.

### [Brief Description of the Drawings]

Figs. 1 and 2 schematically illustrate the configurations (i.e., an exploded view and an assembled view, respectively) of a solar cell module according to an embodiment, which comprises solar cells, encapsulant sheets, and a back sheet.
Fig. 3 shows the reflectance curves of the back sheet obtained in the Examples and the Comparative Examples with respect to wavelength.

**<Description of the Numerals>**

| | |
|---|---|
| 10: solar cell module | 11: solar cell |
| 12: first encapsulant sheet | 12': second encapsulant sheet |
| 13: back sheet | 14: transparent protective sheet |

### [Best Mode for Carrying out the Invention]

Throughout the description of the embodiments, in the case where each layer, hole, window, region, or the like is mentioned to be formed "on" or "under" another layer, hole, window, region, or the like, it means not only that one element is "directly" formed on or under another element, but also that one element is "indirectly" formed on or under another element with other element(s) interposed between them.

In addition, the term "on" or "under" with respect to each element may be referenced to the drawings. For the sake of description, the sizes of individual elements in the appended drawings may be exaggeratingly depicted and do not indicate the actual sizes.

Further, all numerical ranges related to the quantities of physical properties, dimensions, and the like of a component used herein are to be understood as being modified by the term "about," unless otherwise indicated.

### Back sheet for solar cells

The back sheet for solar cells according to an embodiment comprises an infrared reflecting layer comprising a resin and an inorganic pigment, wherein the inorganic pigment comprises a first inorganic pigment comprising bismuth (Bi); and a second inorganic pigment comprising at least two selected from the group consisting of cobalt (Co), magnesium (Mg), nickel (Ni), chromium (Cr), aluminum (Al), zinc (Zn), and titanium (Ti), and the back sheet for solar cells has an average reflectance of 45% or more in a wavelength range of 750 nm to 1,100 nm.

More specifically, the back sheet for solar cells may have an average reflectance of 50% or more, for example, 51% or more, in a wavelength range of 750 nm to 1,100 nm. Reflectance is as measured using a spectrophotometer. An example of a suitable spectrophotometer is the V670 of Jasco.

### Resin

The resin is not particularly limited as long as it can be used for a back sheet for solar cells. For example, it may be at least one selected from the group consisting of a polyolefin resin, a polyethylene terephthalate resin, a polyethylene-vinyl acetate resin, and a polyurethane resin. Specifically, the resin may be a polyethylene resin. More specifically, it may be a low-density polyethylene (LDPE) resin.

The low-density polyethylene resin may have a density of 0.89 g/cm³ to 0.95 g/cm³ at 20°C. Specifically, the low-density polyethylene resin may have a density of 0.89 g/cm³ to 0.92 g/cm³ at 20°C. The resin may have a melt index (MI) of 1 g/10 min to 5 g/10 min at 190°C according to ASTM D 1238. In addition, it may have a melt index (MI) of 1 g/10 min to 3 g/10 min at 23°C.

### Inorganic pigment

The inorganic pigment comprises a first inorganic pigment comprising bismuth (Bi); and a second inorganic pigment comprising at least two selected from the group consisting of cobalt (Co), magnesium (Mg), nickel (Ni), chromium (Cr), aluminum (Al), zinc (Zn), and titanium (Ti). If the back sheet for solar cells comprises the first and second inorganic pigments as described above, it produces the effects that the color of the sheet is black upon transmission of light and that it has a high reflectance in an infrared region (e.g., 750 nm to 1,100 nm), in which the power generation efficiency of a cell is high.

The first inorganic pigment may be brown. For example, it may be a bismuth (Bi)-based metal oxide. Specifically, the first inorganic pigment may be an alloy that comprises (or consists of, or consists essentially of) bismuth (Bi) and copper (Cu). More specifically, the first inorganic pigment may be an alloy that comprises (or consists of, or consists essentially of) bismuth (Bi) and copper (Cu) in a weight ratio of 1:0.3 to 1:0.5.

The second inorganic pigment may be a green pigment. As a specific example, it may be at least one selected from the group consisting of a cobalt (Co)-aluminum (Al) alloy, a cobalt (Co)-chromium (Cr)-aluminum (Al) alloy, a cobalt (Co)-nickel (Ni)-zinc (Zn)-titanium (Ti) alloy, a cobalt (Co)-chromium (Cr)-zinc (Zn)-magnesium (Mg)-aluminum (Al) alloy, a cobalt (Co)-chromium (Cr)-zinc (Zn)-titanium (Ti) alloy, and a cobalt (Co)-chromium (Cr)-aluminum (Al)-zinc (Zn)-titanium (Ti) alloy. Specifically, the second inorganic pigment may be a cobalt (Co)-chromium (Cr)-zinc (Zn)-titanium (Ti) alloy. More specifically, the second inorganic pigment may be an alloy that comprises (or consists of, or consists essentially of) 15 to 30% by weight of cobalt (Co), 15 to 25% by weight of chromium (Cr), 30 to 45% by weight of zinc, and 20 to 35% by weight of titanium (Ti).

The inorganic pigment may comprise 83% by weight to 96% by weight of the first inorganic pigment and 4% by weight to 17% by weight of the second inorganic pigment based on the total weight of the inorganic pigment. Specifically, the inorganic pigment may comprise 85% by weight to 95% by weight of the first inorganic pigment and 5% by weight to 15% by weight of the second inorganic pigment based on the total weight of the inorganic pigment.

The infrared reflecting layer may comprise 8% by weight to 23% by weight of the inorganic pigment based on the total weight of the infrared reflecting layer. Specifically, the infrared reflecting layer may comprise 10% by weight to 20% by weight of the inorganic pigment based on the total weight of the infrared reflecting layer. If the contents are within the above ranges, it is possible to secure a high reflection performance of the produced sheet in a region, in which the power generation efficiency of a cell is high, while the produced sheet maintains black color without being visually observed as purple or green upon transmission of light.

Each of the first inorganic pigment and the second inorganic pigment may have an average particle diameter of 0.5 µm to 3 µm. Specifically, each of the first inorganic pigment and the second inorganic pigment may have an average particle diameter of 0.5 µm to 2 µm. If the particle diameter is within the above range, it is advantageous that the dispersibility in the resin is high, whereby the resin can be easily processed.

In an embodiment, the back sheet for solar cells may have an L* value of 30 or less, an a* value of 0 to 1, and a b* value of 0 to 1 in an L*a*b* color coordinate. Specifically, the back sheet for solar cells may have an L* value of 0 to 29 or 20 to 29, an a* value of 0.5 to 0.9 or 0.6 to 0.9, and a b* value of 0 to 0.5 or 0.3 to 0.5 in an L*a*b* color coordinate.

### Substrate layer

The back sheet for solar cells may further comprise a substrate layer that comprises a white pigment. Specifically, the back sheet for solar cells may have a structure in which an infrared reflecting layer and a substrate layer are sequentially laminated.

The substrate layer may comprise a resin and a white pigment. Specifically, the substrate layer may comprise 10% by weight to 25% by weight of a white pigment based on the total weight of the substrate layer. More specifically, the substrate layer may comprise 10% by weight to 20% by weight of a white pigment based on the total weight of the substrate layer. If the content is within the above range, a film having a high reflection efficiency in an infrared region can be produced.

The white pigment may comprise titanium dioxide. In addition, the white pigment may have an average particle diameter of 0.1 µm to 2.0 µm. Specifically, the white pigment may comprise titanium dioxide and may have an average particle diameter of 0.3 µm to 0.5 µm. If the particle diameter is within the above range, it is possible to produce a sheet having a high reflectance in a near-infrared region.

The substrate layer may have a reflectance of less than 20% at 750 nm and at least 50% on average at 750 nm to 2,000 nm.

### Encapsulant for solar cells

The encapsulant for solar cells according to an embodiment comprises an infrared reflecting layer comprising a resin and an inorganic pigment, wherein the inorganic pigment comprises a first inorganic pigment comprising bismuth (Bi); and a second inorganic pigment comprising at least two selected from the group consisting of cobalt (Co), magnesium (Mg), nickel (Ni), chromium (Cr), aluminum (Al), zinc (Zn), and titanium (Ti), and the encapsulant for solar cells has an average reflectance of 45% or more in a wavelength range of 750 nm to 1,100 nm.

More specifically, the encapsulant for solar cells may have an average reflectance of 50% or more, for example, 51% or more, in a wavelength range of 750 nm to 1,100 nm.

The infrared reflecting layer, the resin, and the inorganic pigment of the encapsulant for solar cells are as described above with respect to the back sheet for solar cells.

### Solar cell module

The solar cell module according to an embodiment comprises the back sheet for solar cells or the encapsulant for solar cells.

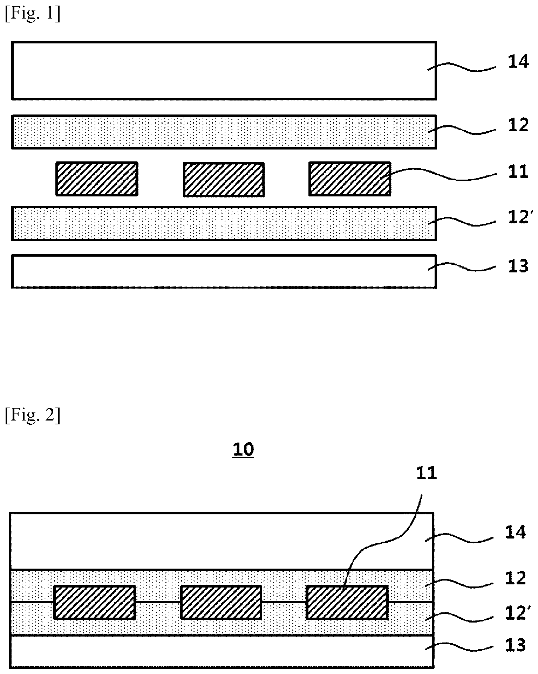

Referring to Figs. 1 and 2, the solar cell module (10) may comprise a solar cell (11) made of amorphous or polycrystalline silicon; at least one encapsulant sheet (12, 12') laminated on at least one side of the solar cell (11); and a back sheet (13) laminated on one side of any of the encapsulant sheets. As a specific example, the solar cell module (10) may comprise a transparent protective sheet (14), a first encapsulant sheet (12), at least one solar cell (11) connected to an electrode, a second encapsulant sheet (12'), and a back sheet (13), all of which are laminated in this order.

In such event, the back sheet (13) may be the back sheet for solar cells as described above. That is, the back sheet (13) may comprise an infrared reflecting layer as described above. In an embodiment, the back sheet (13) may further comprise the substrate layer as described above, together with the infrared reflecting layer.

In addition, the second encapsulant sheet (12') may be the encapsulant for solar cells, which comprises the infrared reflecting layer as described above. In an embodiment, the second encapsulant sheet (12') may be composed of the infrared reflecting layer.

In the solar cell module, sunlight enters the solar cell through the transparent protective sheet (14) and is converted into electric energy. In such event, the encapsulant for solar cells, which comprises the infrared reflecting layer as described above, is not applied to the first encapsulant sheet (12) adjacent to the transparent protective sheet (14). That is, the first encapsulant sheet (12) transmits light at a transmittance of 80% or more in a region (e.g., 750 nm to 1,100 nm), in which the power generation efficiency of a cell is high. In addition, the encapsulant for solar cells, which comprises the infrared reflecting layer as described above, may be applied to the second encapsulant sheet (12'). Thus, the reflected light can be further incident on the solar cell (11), thereby enhancing the efficiency of the solar cell.

The solar cell module (10) as described above may be prepared by laminating the constituent layers inclusive of the solar cell (11), the encapsulant sheets (12 and 12'), and the back sheet in order and then processing (e.g., heating and pressing) them. In such event, the back sheet (13) may be the back sheet for solar cells as described above. In addition, the encapsulant sheet (12') to be laminated to the back sheet among the encapsulant sheets may be the encapsulant for solar cells as described above.

The solar cell (11), the encapsulant sheet (12), and the transparent protective substrate (14) that constitute the solar cell module (10) may be appropriately selected from those conventionally used.

### [Example]

Hereinafter, the present invention is explained in detail by the following Examples. However, the scope of the present invention is not limited thereto only.

### Example 1

### 1-1: Preparation of an infrared reflecting layer

85% by weight of a low-density polyethylene (LDPE) resin (manufacturer: Hanwha Chemical, product name: 963 with a melt index at 190°C of 3 g/10 min and a density at 20°C of 0.92 g/cm³) was mixed with 15% by weight of a pigment mixture to prepare a resin composition.

The pigment mixture was prepared by mixing 90% by weight of a dark brown infrared reflective inorganic pigment (manufacturer: TOMATEC, product name: 42-713A, a Bi-Cu alloy) as a first inorganic pigment and 10% by weight of a green infrared reflective inorganic pigment (manufacturer: Shepherd, product name: Green 410, a CoCrAlZnTi alloy).

Thereafter, the resin composition was extruded to prepare an infrared reflecting layer having a thickness of 65 µm.

### 1-2: Preparation of a substrate layer

85% by weight of a polyethylene terephthalate (PET with a weight average molecular weight of 30,000 g/mole) was mixed with 15% by weight of TiO2 (average particle diameter: 0.3 µm), which was extruded to prepare a substrate layer having a thickness of 165 µm.

Thereafter, the infrared reflecting layer of the above step 1-1 and the substrate layer were laminated to each other by using a dry laminate adhesive (manufacturer: Toyo Morton, product name: LIS 7210) to produce a back sheet for solar cells that was black when viewed from the side of the light receiving surface.

### Examples 2 to 9

Back sheets for solar cells were prepared in the same manner as in Example 1, except that the content of the inorganic pigment mixture in the resin or the content ratio of the first inorganic pigment and the second inorganic pigment of the infrared reflective pigment were changed as shown in Table 1 below.

### Comparative Example 1

A back sheet for solar cells was prepared in the same manner as in Example 1, except that 3% by weight of carbon black (manufacturer: OCI, product name: DC2500G) was used instead of the pigment mixture.

### Comparative Example 2

A back sheet for solar cells was prepared in the same manner as in Example 1, except that an infrared reflective inorganic pigment of black color (manufacturer: Asahi Industry, product name: Black 6302, an Mn-Sr composite oxide) was used in an amount of 15% by weight instead of the pigment mixture.

### Comparative Example 3

A back sheet for solar cells was prepared in the same manner as in Example 1, except that a mixture of 95% by weight of an infrared reflective inorganic pigment of green color (manufacturer: Shepherd, product name: Green 410, CoCrAlZnTi) and 5% by weight of an infrared reflective organic pigment of red color (manufacturer: BASF, product name: L 3875, a red azo-based perylene pigment) was used in an amount of 20% by weight instead of the pigment mixture.

### Comparative Example 4

A back sheet for solar cells was prepared in the same manner as in Example 1, except that a conventional infrared reflective inorganic pigment of black color (manufacturer: Shepherd, product name: Black 10P922) was used in an amount of 15% by weight instead of the pigment mixture.

**[Table 1]**

| | Pigment type | The pigment content in the resin composition (% by weight) | Weight ratio of the first inorganic pigment to the second inorganic pigment |
|---|---|---|---|
| Ex. 1 | Bi-Cu (first inorganic pigment) and CoCrAlZnTi (second inorganic pigment) | 15 | 90:10 |
| Ex. 2 | | 15 | 95:5 |
| Ex. 3 | | 15 | 85:15 |
| Ex. 4 | | 10 | 90:10 |
| Ex. 5 | | 20 | 90:10 |
| Ex. 6 | | 15 | 97:3 |
| Ex. 7 | | 15 | 82:18 |
| Ex. 8 | | 5 | 90:10 |
| Ex. 9 | | 25 | 90:10 |
| C. Ex. 1 | Carbon black | 3 | - |
| C. Ex. 2 | Mn-Sr (inorganic pigment) | 15 | - |
| C. Ex. 3 | CoCrAlZnTi (inorganic pigment) and azo-based perylene pigment (organic pigment) | 20 | - |
| C. Ex. 4 | Conventional black infrared reflective inorganic pigment | 15 | - |

### Test Example: Evaluation of color, concealment, color upon transmission of light, and reflectance

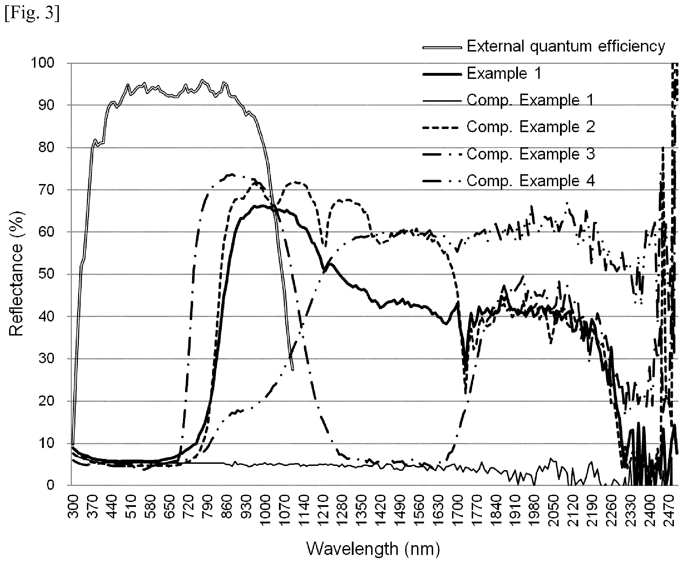

The back sheets of Examples 1 to 9 and Comparative Examples 1 to 4 were subjected to evaluation of the color and concealment for the implementation of black color and the color upon transmission of light. They were also measured for the reflectance of light in the wavelength range of 750 nm to 1,100 nm. The results are shown in Table 3 below and Fig. 3.

### (1) Color and concealment

Each back sheet was subjected to evaluation of the color and concealment for the degree of implementation of black color. Specifically, the L*a*b* color coordinate was measured using the Ultrascan pro of Hunterlab. The color was determined based on Table 2 as a measurement result. But it was difficult to determine the L*a*b* color coordinates in Comparative Examples 1 to 4 in which the pigments other than those in the Examples were used.

In addition, the concealment was evaluated by preparing a laminate having a structure of glass/EVA/electrode/EVA/back sheet and measuring the level of visibility of the electrode when light was irradiated thereon.

**[Table 2]**

| | Color determination criteria | Concealment determination criteria |
|---|---|---|
| ○○ | L* < 28, 0.6 ≤ a* ≤ 1, 0.2 ≤ b* ≤ 1 | Not visible |
| ○ | 28 ≤ L* ≤ 31,0.6 ≤ a* ≤ 1, 0.2 ≤ b* ≤ 1 | Hardly visible |
| X | 28 ≤ L* ≤ 31,1 < a*, 1 < b* | Visible |

### (2) Color upon transmission of light

While light was irradiated using an LED lamp on the rear side of the back sheet, the visible color was determined.

### (3) Reflectance

Each back sheet was measured for the reflectance in a reflection mode at a wavelength of 300 nm to 2,500 nm using a spectrophotometer (manufacturer: Jasco, product name: V670). Specifically, the average reflectance at 750 nm, 750 nm to 1,100 nm, and 750 nm to 2,000 nm was measured. In addition, the reflectance in a light source range of 300 nm to 2,500 nm was measured. The results are shown in Fig. 3. Here, the external quantum efficiency (QE) curve of the solar cell is also shown for reference. A silicon cell (IM156B3 from MOTEC) was used as a solar cell for measuring the external quantum efficiency.

**[Table 3]**

| Item | Color | | | | Concealment | Color upon light transmission | Reflectance (%) | | |
|---|---|---|---|---|---|---|---|---|---|
| | L* | a* | b* | Deter mination | | | Near visible light (750 nm) | Infrared region of high external QE (750-1100 nm) | Infrared region (750-2000 nm) |
| Ex. 1 | 27.97 | 0.74 | 0.46 | ○○ | ○○ | Black | 9.9 | 51 | 46.5 |
| Ex. 2 | 28.20 | 0.88 | 0.38 | ○ | ○○ | Black | 9.8 | 51.5 | 48.8 |
| Ex. 3 | 27.87 | 0.68 | 0.48 | ○○ | ○○ | Black | 9.4 | 50.1 | 45.3 |
| Ex. 4 | 27.87 | 0.73 | 0.46 | ○○ | ○ | Black | 10.3 | 51.6 | 47 |
| Ex. 5 | 27.97 | 0.73 | 0.45 | ○○ | ○○ | Black | 9.6 | 50.2 | 45.3 |
| Ex. 6 | 28.91 | 1.05 | 0.22 | X | ○○ | Black | 10.2 | 50.1 | 50.8 |
| Ex. 7 | 27.97 | 0.62 | 0.61 | ○○ | ○○ | Black | 9.7 | 48.7 | 45.3 |
| Ex. 8 | 29.15 | 0.83 | 0.46 | ○ | X | Black | 10.9 | 50.9 | 46.9 |
| Ex. 9 | 27.91 | 0.88 | 0.44 | ○○ | ○○ | Black | 9.2 | 47.2 | 43.8 |
| C. Ex. 1 | 25.80 | -0.01 | -0.39 | ○○ | ○○ | Black | 5.3 | 5.1 | 4.4 |
| C. Ex. 2 | 25.25 | -0.09 | -1.32 | ○○ | ○○ | Green | 7.2 | 55.3 | 54.4 |
| C. Ex. 3 | 30.55 | -1.13 | -2.68 | ○ | ○○ | Purple | 57.6 | 68.1 | 33.7 |
| C. Ex. 4 | 26.05 | 1.61 | 0.22 | ○○ | ○○ | Black | 6.8 | 18.1 | 45.8 |

As shown in Table 3 above, the back sheets of Examples 1 to 9 had a reflectance of 45% or more in an infrared region (i.e., 750 nm to 1,100 nm), in which the external quantum efficiency of a solar cell is high, while it is viewed as black. Thus, they can be applied to various fields.

In particular, the back sheets of Examples 1 to 5 are more excellent in terms of the reflectance in an infrared region (wavelength of 750 nm to 1,100 nm), in which the color, concealment, and the external quantum efficiency of a solar cell are high, since the content of the pigment in the resin and the content ratio of the first inorganic pigment to the second inorganic pigment are more limited, as compared with the back sheets of Examples 6 to 9.

Meanwhile, in the case of Comparative Example 1 that used carbon black and Comparative Example 4 that used a conventional black infrared reflective inorganic pigment, the reflectance at an infrared region (wavelength of 750 nm to 1,100 nm), in which the external quantum efficiency of a solar cell is high, was significantly lower than those of the Examples.

In addition, the sheets of Comparative Example 2 that used an inorganic pigment different from that of the Examples and Comparative Example 2 that used a mixture of an inorganic pigment and an organic pigment were viewed as a different color from black upon transmission of light. Thus, it is difficult for them to be applied to a field requiring a sheet of black color.

## Claims

1. A back sheet for solar cells, which comprises:
an infrared reflecting layer comprising a resin and an inorganic pigment,
wherein the inorganic pigment comprises
a first inorganic pigment comprising bismuth (Bi); and
a second inorganic pigment comprising at least two selected from the group consisting of cobalt (Co), magnesium (Mg), nickel (Ni), chromium (Cr), aluminum (Al), zinc (Zn), and titanium (Ti), and
the back sheet for solar cells has an average reflectance of 45% or more in a wavelength range of 750 nm to 1,100 nm.

2. The back sheet for solar cells of claim 1, which has an L* value of 30 or less, an a* value of 0 to 1, and a b* value of 0 to 1 in an L*a*b* color coordinate.

3. The back sheet for solar cells of claim 1 or claim 2, wherein the infrared reflecting layer comprises 8% by weight to 23% by weight of the inorganic pigment based on the total weight of the infrared reflecting layer.

4. The back sheet for solar cells of any one of the preceding claims, wherein the inorganic pigment comprises 83% by weight to 96% by weight of the first inorganic pigment and 4% by weight to 17% by weight of the second inorganic pigment based on the total weight of the inorganic pigment.

5. The back sheet for solar cells of any one of the preceding claims, wherein the first inorganic pigment is a bismuth (Bi)-based metal oxide.

6. The back sheet for solar cells of any one of claims 1-4, wherein the first inorganic pigment is an alloy that comprises bismuth (Bi) and copper (Cu).

7. The back sheet for solar cells of any one of the preceding claims, wherein the second inorganic pigment is at least one selected from the group consisting of a cobalt (Co)-aluminum (Al) alloy, a cobalt (Co)-chromium (Cr)-aluminum (Al) alloy, a cobalt (Co)-nickel (Ni)-zinc (Zn)-titanium (Ti) alloy, a cobalt (Co)-chromium (Cr)-zinc (Zn)-magnesium (Mg)-aluminum (Al) alloy, a cobalt (Co)-chromium (Cr)-zinc (Zn)-titanium (Ti) alloy, and a cobalt (Co)-chromium (Cr)-aluminum (Al)-zinc (Zn)-titanium (Ti) alloy.

8. The back sheet for solar cells of any one of the preceding claims, wherein the resin is at least one selected from the group consisting of a polyolefin resin, a polyethylene terephthalate resin, a polyethylene-vinyl acetate resin, and a polyurethane resin.

9. The back sheet for solar cells of any one of the preceding claims, which further comprises a substrate layer that comprises a white pigment.

10. The back sheet for solar cells of claim 9, wherein the white pigment comprises titanium dioxide and has an average particle diameter of 0.3 µm to 0.5 µm.

11. The back sheet for solar cells of claim 9 or claim 10, wherein the substrate layer comprises 10% by weight to 25% by weight of the white pigment based on the total weight of the substrate layer.

12. An encapsulant for solar cells, which comprises:
an infrared reflecting layer comprising a resin and an inorganic pigment,
wherein the inorganic pigment comprises a first inorganic pigment comprising bismuth (Bi); and a second inorganic pigment comprising at least two selected from the group consisting of cobalt (Co), magnesium (Mg), nickel (Ni), chromium (Cr), aluminum (Al), zinc (Zn), and titanium (Ti), and
the encapsulant for solar cells has an average reflectance of 45% or more in a wavelength range of 750 nm to 1,100 nm.

13. A solar cell module, which comprises the back sheet for solar cells of any one of claims 1-11; and/or the encapsulant for solar cells of claim 12.
